Europäisches Patentamt

European Patent Office

Office européen des brevets

(11) Veröffentlichungsnummer: **0 411 484 A1**

# EUROPÄISCHE PATENTANMELDUNG

(21) Anmeldenummer: **90114416.2**

(51) Int. Cl.⁵: **H05K 5/00**

(22) Anmeldetag: **27.07.90**

(30) Priorität: **03.08.89 DE 3925633**

(43) Veröffentlichungstag der Anmeldung:
**06.02.91 Patentblatt 91/06**

(84) Benannte Vertragsstaaten:
**DK ES FR GB IT SE**

(71) Anmelder: **DR. E. HORN GMBH**
**Im Vogelsang 1**
**D-7036 Schönaich(DE)**

(72) Erfinder: **Wüscht, Hans**
**Elsenhalde 29**

**D-7036 Schönaich(DE)**
Erfinder: **Frintrop, Henry**
**Stettiner Strasse 12**
**D-7014 Kornwestheim(DE)**
Erfinder: **Renneberg, Paul-Jörg**
**Meisenweg 24**
**D-7273 Rotfelden(DE)**

(74) Vertreter: **Patentanwälte Kohler - Schwindling**
**- Späth**
**Hohentwielstrasse 41**
**D-7000 Stuttgart 1(DE)**

(54) **Gehäuse für Instrumente.**

(57) Bei einem Gehäuse (1) für Instrumente, wie Anzeigeinstrumente, Meßinstrumente, Schalterinstrumente oder dergleichen, zum Einbau in eine einen Ausschnitt (60) aufweisende Trägerplatte (27), wobei das Gehäuse (1) vier Seitenwände (2 bis 5) und eine Frontwand aufweist, wird eine einfache Blockmontage mehrerer Gehäuse (1) aneinander sowie ein einfacher Einbau einzelner Gehäuse (1) und eines Gehäuseblocks in den Ausschnitt (60) der Trägerplatte (27) dadurch erreicht, daß jede Seitenwand (2 bis 5) eine Steckverbindung (22) aufweist, mit der die Steckverbindung (22) einer Seitenwand (2 bis 5) eines benachbarten Gehäuses (1) derart verbindbar ist, daß die beiden Gehäuse (1) fest aneinander gekoppelt sind. Diese Gehäuse (1) bedürfen keiner zusätzlichen Befestigungselemente bzw. Einbauteile für den Einbau in Ausschnitte (60) von Trägerplatten (27).

Fig. 1

EP 0 411 484 A1

## GEHÄUSE FÜR INSTRUMENTE

Die Erfindung betrifft ein Gehäuse für Instrumente, wie Anzeigeinstrumente, Meßinstrumente, Schaltinstrumente, Steuergeräte oder dergleichen, zum Einbau in eine einen Ausschnitt aufweisende Trägerplatte, wobei das Gehäuse vier Seitenwände und eine Frontwand aufweist.

Instrumente, wie digitale, analoge, digital-analoge oder analog-digital Anzeigegeräte, insbesondere Geräte nach Bauform DIN 43 700, besitzen in der Regel ein Gehäuse, in dem die Instrumente oder Schalt- und Steuergeräte angeordnet sind und das als Schutz für die Instrumente oder Schalt- und Steuergeräte dient. Die Gehäuse können einerseits so ausgebildet sein, daß sie zum direkten Gebrauch der Instrumente dienen, andererseits als Einbaugehäuse ausgebildet sein, so daß die Instrumente, z.B. als Teil einer größeren Einheit, in Schalttafeln, Schaltwarten, oder anderen Trägerplatten für Elektronik, Elektrotechnik oder Elektromechanik eingebaut werden können. Zum Einbau derartiger Gehäuse weisen die Trägerplatten Ausschnitte auf, durch die die Gehäuse eingeschoben und an der Rückseite der Trägerplatte befestigt werden können. Auf diese Weise können eine Vielzahl von Instrumenten zusammengesetzt und miteinander kombiniert werden. Bei der Ausgestaltung der Gehäuse für die Instrumente ist darauf zu achten, daß aus Kostengründen und Vereinheitlichung der Gehäuse diese in Trägerplatten mit unterschiedlichen Dicken einbaubar sein müssen und die Befestigung der Gehäuse an den Trägerplatten einfach durchführbar sein soll.

Mit der DE-PS 32 14 528 ist ein Gehäuse bekannt, mit dem Instrumente in Trägerplatten einbaubar sind. Diese Gehäuse können entweder einzeln oder zu mehreren im Blockverbund in entsprechende Ausschnitte in Trägerplatten eingesetzt werden. Hierfür weisen die Gehäuse jedoch zusätzliche Einbauteile auf, über die sie einerseits an der Rückseite der Trägerplatte gehalten werden, andererseits beim Blockverbund die zwei oder mehreren Gehäuse miteinander verbinden. Die Verwendung von zusätzlichen Einbauteilen ist jedoch umständlich, da sie stets mit dem Gehäuse mitgeliefert werden müssen, bzw. Gehäuse ohne derartige Einbauteile nicht eingebaut werden können. Außerdem ist die Montage derartiger Gehäuse mit Hilfe der Einbauteile umständlich und erfordert Geduld und Geschick, da die Einbauteile von der Rückseite zwischen die einzelnen Gehäuse eingesteckt und diese dadurch verbunden werden müssen. Weiterhin ist von Nachteil, daß mehrere Gehäuse vor dem Einbau nicht zu einem Blockverbund kombiniert werden können, sondern die Gehäuse erst nach ihrem Einsetzen in den Ausschnitt der Trägerplatte umständlich und daher zeitaufwendig zu einem Block montiert werden können.

Der Erfindung liegt daher die Aufgabe zugrunde, ein Gehäuse der eingangs genannten Art derart weiterzubilden, daß es kostengünstig herstellbar und sowohl einzeln in eine Trägerplatte eingebaut werden kann, als auch als Block vormontierbar und erst dann einbaubar ist, wobei der Einbau einfach und schnell durchführbar sein soll.

Diese Aufgabe wird erfindungsgemäß dadurch gelöst, daß jede Seitenwand eine Steckverbindung aufweist, mit der die Steckverbindung einer Seitenwand eines benachbarten Gehäuses derart verbindbar ist, daß die beiden Gehäuse fest aneinander gekoppelt sind.

Für das Aneinanderkoppeln der einzelnen Gehäuse zum Aufbau eines Gehäuseblocks werden keine zusätzlichen Einbauteile oder Befestigungselemente benötigt, da an jedem Gehäuse die erforderlichen Elemente bereits angeformt sind. Demnach können keine Einbauteile oder Befestigungselemente verlorengehen bzw. müssen diese Teile nicht in einem Beipack mit dem Gehäuse mitgeliefert werden. Die Seitenwände des Gehäuses sind jeweils mit einer Steckverbindung versehen, über die das Gehäuse mit einem oder mehreren weiteren Gehäusen verbindbar ist, so daß das Gehäuse als Block vormontierbar und schließlich als Block in einen einzigen Ausschnitt der Trägerplatte einsetzbar und dort befestigbar ist. Das erfindungsgemäße Gehäuse hat demnach den Vorteil, daß es bereits vor dem Einbau in die Trägerplatte mit anderen Gehäusen verbindbar ist, wodurch der nachfolgende Einbau wesentlich erleichtert und beschleunigt wird. Das erfindungs gemäße Gehäuse kann sofort ohne zusätzliche Hilfsmittel entweder einzeln oder zu mehreren in die Trägerplatte eingebaut werden.

Eine vorteilhafte Weiterbildung sieht vor, daß jede Seitenwand eine angeformte, in der Ebene der Seitenwand liegende Steckverbindung aufweist, mit der die an einer Seitenwand eines benachbarten Gehäuses angeformte Steckverbindung derart verbindbar ist, daß die beiden Gehäuse fest aneinander gekoppelt sind, wobei die Steckverbindungen federnd ausgebildet sind.

Gemäß einer bevorzugten Ausführungsform ist die Steckverbindung als Nut-Feder-Verbindung ausgebildet. Diese Ausführungsform der Steckverbindung, bei der auf der einen Seite eine Nut und auf der anderen Seite eine entsprechende, in die Nut passende Feder vorgesehen ist, besitzt den wesentlichen Vorteil, daß sie durch einfaches Einschieben hergestellt werden kann. Eine spezielle Ausführungsform sieht vor, daß die Nut-Feder-Verbindung als Schwalbenschwanz-Führung ausgebildet ist. Hier ist die eine Seitenwand mit einer Schwalbenschwanz-Nut und die Seitenwand des anderen Gehäuses mit einer Schwalbenschwanz-Feder ausgestattet. Eine derartige Vorrichtung ist leicht herzustellen und einerseits leicht zu verbinden, andererseits stellt eine derartige Verbindung einen sicheren Halt dar, so daß die beiden Gehäuse sicher miteinander verbunden sind.

Eine bevorzugte Ausführungsform sieht vor, daß die Steckverbindung positive und negative Führungsstücke aufweist, wobei an zwei nebeneinanderliegenden, d. h. benachbarten Seitenwänden jeweils ein positives Führungsstück und an den anderen Seitenwänden jeweils ein negatives Führungsstück vorgesehen ist. Als positives bzw. negatives Führungsstück wird hier z.B. eine Nut bzw. eine Feder verstanden, wobei die positiven und negativen Führungsstücke derart ausgebildet sind, daß sie ineinanderfügbar sind und nach dem Zusammenfügen aneinander halten. Dadurch, daß jedes Gehäuse mit zwei positiven und zwei negativen Führungsstücken ausgebildet ist, wobei einander gegenüberliegende Seitenwände mit unterschiedlichen Führungsstücken versehen sind, kann mit einer einzigen Gehäuseform jede denkbare Form eines Blocks aufgebaut werden. Es können somit mehrere Gehäuse seitlich nebeneinander oder übereinander oder sowohl nebeneinander als auch übereinander zu einem Block zusammengefügt werden. Dieser Block ist ebenfalls vormontierbar und schließlich in die Trägerplatte einbaubar.

Bevorzugt sind die Steckverbindungen in einer senkrecht zur Ebene der Trägerplatte verlaufenden Richtung miteinander verbindbar. Dies hat den Vorteil, daß aus einem bereits zusammengefügten Gehäuseblock ein beliebiges Gehäuse wieder herausnehmbar und wieder einsetzbar ist, ohne daß der Block vorher in seine einzelnen Gehäuse zerlegt werden muß. Die Gehäuse sind aus der Ebene des Blocks durch senkrechtes Aus- bzw. Einschieben lösbar bzw. befestigbar.

Gemäß einer bevorzugten Ausführungsform weisen die Steckverbindungen Arretierrasten auf, die die Gehäuse in einer Lage festhalten, in der ihre Frontwände bündig miteinander abschließen. Die Arretierrasten gewähren eine genaue Lage der Gehäuse zueinander, so daß bei der Erstellung eines Gehäuseblocks die Gehäuse soweit miteinander mit ihren Steckverbindungen zu verbinden sind, bis die Arretierrasten ineinander einrasten. Die Verrastung gewährleistet einerseits einen zusätzlichen sicheren Halt gegen ein unzeitiges Ausschieben eines Gehäuses aus dem Gehäuseblock, andererseits gewährleisten sie einen bündigen, frontseitigen Abschluß der einzelnen Gehäusestirnwände bzw. deren Frontwände, so daß der Block nach dem Einbau in die Trägerplatte ein ebenes, bündiges Frontbild aufweist.

Vorteilhaft sind, wie bereits oben beschrieben, die Gehäuse vor dem Einbau in die Trägerplatte als Block vormontierbar. Dies hat den Vorteil einer wesentlich einfacheren Handhabung der Gehäuse und, nach der Erstellung des Gehäuseblocks, einen wesentlich einfacheren, zeitsparenden und sicheren und daher kostengünstigeren Einbau desselben in die Trägerplatte. Zudem können vor dem Einbau des Blocks in die Trägerplatte die einzelnen in den Gehäusen des Blocks sich befindenden Meßgeräte bzw. Instrumente einfacher miteinander verbunden werden.

Vorteilhaft sind die Steckverbindungen in Führungsschienen vorgesehen. Die Führungsschienen dienen zugleich als Steckverbindung und als Führung für die Gehäuse beim Zusammenfügen derselben zu einem Gehäuseblock.

Bei einer Ausführungsform ist vorgesehen, daß die Führungsschienen als federnde Zungen ausgebildet sind. Dies hat den Vorteil, daß die einzelnen zu einem Block miteinander verbundenen Gehäuse in einem begrenzten Maße elastisch miteinander verbunden sind, und dadurch z.B. wärmebedingte Spannungen abgebaut werden können. Bevorzugt erstrecken sich die Zungen über etwa die Hälfte der Gehäuselänge. Dabei liegen die Zungen in der Ebene der Seitenwände. Das Gehäuse ist somit zuverlässig funktionsfähig in einem Temperaturbereich von etwa -20° bis etwa +100° C.

Bei einem bevorzugten Ausführungsbeispiel ist vorgesehen, daß zwei einander gegenüberliegende Seitenwände Befestigungshalter aufweisen, über die sich das Gehäuse an der Rückseite der Trägerplatte abstützt. Vorteilhaft sind hierfür ebenfalls keine zusätzlichen Befestigungselemente bzw. Einbauteile notwendig. Außerdem kann aufgrund der einstückigen Ausbildung der Befestigungshalter mit den Seitenwänden des Gehäuses eine sichere Festlegung des Gehäuses am Ausschnitt der Trägerplatte gewährleistet werden.

Bevorzugt ist zur Abstützung des Gehäuses an der Rückseite der Trägerplatte in jedem Befestigungshalter eine in diesem geführte Schraube vorgesehen. Durch Verstellen der Schraube kann das Gehäuse an unterschiedliche Trägerplatten mit variablen Dicken angepaßt werden. Ein Entfernen bzw. Lösen des bzw. der Gehäuse von der Trägerplatte wird einfach durch ein Lösen der Schrauben erzielt.

Bevorzugt ist der Befestigungshalter als federnde Zunge ausgebildet oder an einer federnden Zunge angeformt. Dies hat den Vorteil, daß das Gehäuse trotz Festlegung mittels einer Schraube in gewissem Maße begrenzt elastisch an der Trägerplatte gehalten ist.

Bei einem Ausführungsbeispiel ist vorgesehen, daß der Befestigungshalter eine Schrägkante aufweist, die beim Einschieben des Gehäuses in den Ausschnitt der Trägerplatte am Rand des Ausschnitts angreift und die federnde Zunge auslenkt, die nach dem Einschieben hinter der Trägerplatte in ihre Ausgangslage zurückspringt. Demnach bietet der Befestigungshalter eine zusätzliche Rastsicherung, so daß das Gehäuse nach dem Einführen in den Ausschnitt der Trägerplatte in dieser verrastet ist und lediglich mittels der Schrauben die Frontwand des Gehäuses an die Außenseite der Trägerplatte herangezogen werden muß. Nach dem Lösen der Schrauben befindet sich das Gehäuse zwar mit Spiel im Ausschnitt der Trägerplatte, wird in diesem jedoch über die Befestigungshalter noch sicher gehalten, da diese die Kontur des Ausschnitts übergreifen, so daß das Gehäuse erst durch Auslenken der als federnde Zungen ausgebildeten Befestigungshalter, wodurch die Hintergreifung gelöst wird, aus dem Ausschnitt der Trägerplatte ausgeschoben und entfernt werden kann.

Bei einem bevorzugten Ausführungsbeispiel ist vorgesehen, daß die stirnseitigen und rückwärtigen Enden der Seitenwände mit Aufnahmen für die Frontwand bzw. den Deckel ausgebildet sind. Das Gehäuse kann über diese Aufnahmen jeweils mit einem rückwärtigen Deckel und einer stirnseitigen Frontwand versehen werden, so daß das in dem Gehäuse angeordnete Instrument bzw. Anzeigegerät vollständig von Gehäusewänden umgeben ist. Diese Frontwand und der Deckel können entweder vor dem Einbau des Gehäuses in die Trägerplatte bzw. nach dessen Einbau an den Stirnenden der Seitenwände angebracht werden.

Bevorzugt sind die Aufnahmen als Ausnehmungen für Rastnasen ausgebildet. Der rückwärtige Deckel und die stirnseitige Frontwand weisen Rastnasen auf, die beim Aufsetzen des Deckels bzw. der Frontwand in die als Ausnehmungen ausgebildete Aufnahmen einrasten und den Deckel bzw. die Frontwand sicher an den Seitenwänden halten. Bevorzugt sind die Rastnasen hakenförmig ausgebildet.

Bei einer Ausführungsform ist vorgesehen, daß die Frontwand als Scheibe ausgebildet ist, insbesondere nach Bauform DIN 43 718. Diese kann entweder klar oder farbig als Kunststoffscheibe oder Glasscheibe ausgeführt sein, sie kann auch als Aluminiumplatte ausgebildet sein, die als Frontplatte mit Vorwahlschaltern dient, welche hinter einer Scheibe liegen.

Ein einfacher Anschluß des Instruments bzw. eine einfache Verbindung der einzelnen im Gehäuseblock sich befindenden Instrumente untereinander und mit den Versorgungs- bzw. Auswerteeinheiten wird dadurch erreicht, daß der rückwärtige Deckel Steckerdurchführungen aufweist.

Eine sichere Festlegung des Instruments bzw. Anzeigegeräts im Gehäuse wird über Platinenführungsschienen, insbesondere mit Platinensicherungen erreicht, wobei die Platinen in die Führungsschienen soweit eingeschoben werden, bis sie mit den Platinensicherungen verrasten und somit sicher im Gehäuse festgelegt sind. Zu Prüf- bzw. Wartungszwecken sind diese Platinen leicht wieder aus ihren Führungsschienen entfernbar, ohne daß das Gehäuse von der Trägerplatte entfernt werden muß. Die Platinensicherungen weisen den Vorteil auf, daß sie eine eingeschobene Platine so fixieren, daß das Gehäuse mit integriertem Instrument in jeder Einbaulage, d.h. auch in vertikaler Lage verwendet werden kann ohne die Gefahr, daß sich das Anzeigeinstrument, bzw. sich die Platinen im Gehäuse lösen oder verrutschen. Das Gehäuse kann demnach auch für mobil einzusetzende Instrumente oder Anzeigegeräte verwendet werden.

Ein dichter Abschluß der Frontwand mit den Seitenwänden wird dadurch erreicht, daß die Frontwand auf ihrer den Seitenwänden zugewandten Seite einen umlaufenden Rand aufweist, der in eine in den Stirnflächen der Seitenwände vorgesehene Nut eingreift. Dieser in die Nut eingreifende Rand gewährt eine gute Abdichtung des Gehäuses, die durch die Verwendung von einem zusätzlichen Dichtungsmittel, z.B. Silikondichtungsmittel noch weiter ver bessert werden kann, so daß eine Abdichtung gemäß der Schutzart IP 54 bzw. IP 56, d.h. gegen Staub und Schwall- bzw.Spritzwasser gewährleistet ist.

Weitere Vorteile, Einzelheiten und Merkmale der Erfindung ergeben sich aus der nachfolgenden Beschreibung, in der unter Bezugnahme auf die Zeichnung ein besonders bevorzugtes Ausführungsbeispiel des erfindungsgemäßen Gehäuses im einzelnen beschrieben ist. Dabei zeigen:

Fig. 1 eine Draufsicht auf das Gehäuse mit angedeuteter Trägerplatte;

Fig. 2 eine Seitenansicht auf das Gehäuse entsprechend der Blickrichtung II gemäß Fig. 1;

Fig. 3 ein Blick auf das frontseitige Ende des Gehäuses, entsprechend der Blickrichtung III gemäß Fig. 1;

Fig. 4 ein Blick auf das rückwärtige Ende des Gehäuses, entsprechend der Blickrichtung IV gemäß Fig. 1;

Fig. 5 einen Schnitt V - V gemäß Fig. 1;

Fig. 6 einen Ausschnitt VI gemäß Fig. 1, einen Befestigungshalter zeigend;

Fig. 7 eine Ansicht auf die Innenseite einer Frontwand;

Fig. 8 einen Schnitt VIII - VIII gemäß Fig. 7, den umlaufenden Rand und eine Rastnase einer Frontwand zeigend;

Fig. 9 eine Ansicht auf die Innenseite eines Deckels; und

Fig. 10 eine Seitenansicht des Deckels.

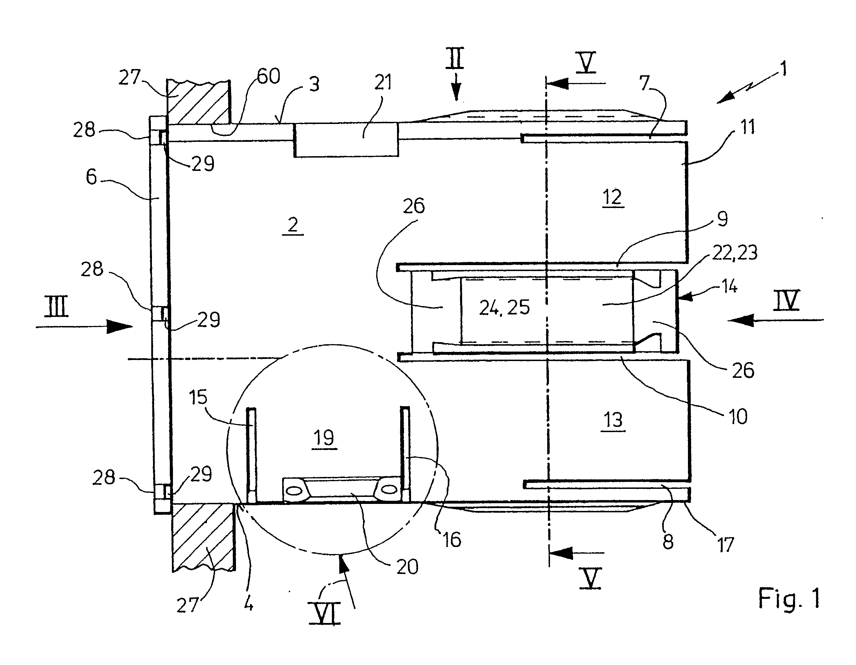

Bei der in der Fig. 1 wiedergegebenen Darstellung ist ein insgesamt mit 1 bezeichnetes Gehäuse, das als Einbaugehäuse ausgebildet ist, gezeigt. Dieses Gehäuse 1 besitzt vier Seitenwände 2 bis 5, wobei die Seitenwände 2 bis 5 an ihren stirnseitigen Enden einen Umfangswulst 6 aufweisen. Die Seitenwand 2 ist mit Schlitzen 7 bis 10 versehen, die sich vom rückwärtigen Ende 11 des Gehäuses 1 über einen Teil der Länge der Seitenwand 2 erstrecken. Dabei bilden die Schlitze 7 und 9 einen ersten Gehäusewandlappen 12 und die Schlitze 8 und 10 einen zweiten Gehäusewandlappen 13. Die Schlitze 9 und 10 bilden eine federnde Zunge 14, die sich vom rückwärtigen Ende 11 etwa über die halbe Länge der Seitenwand 2 erstreckt. Sowohl der erste und zweite Gehäusewandlappen 12 und 13 als auch die federnde Zunge 14 sind einstückig mit der Seitenwand 2 verbunden und liegen in der Ebene der Seitenwand 2.

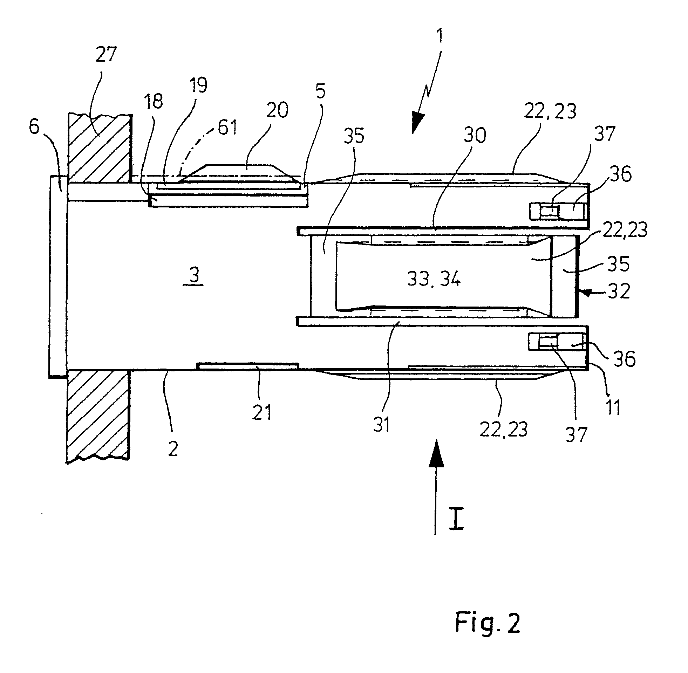

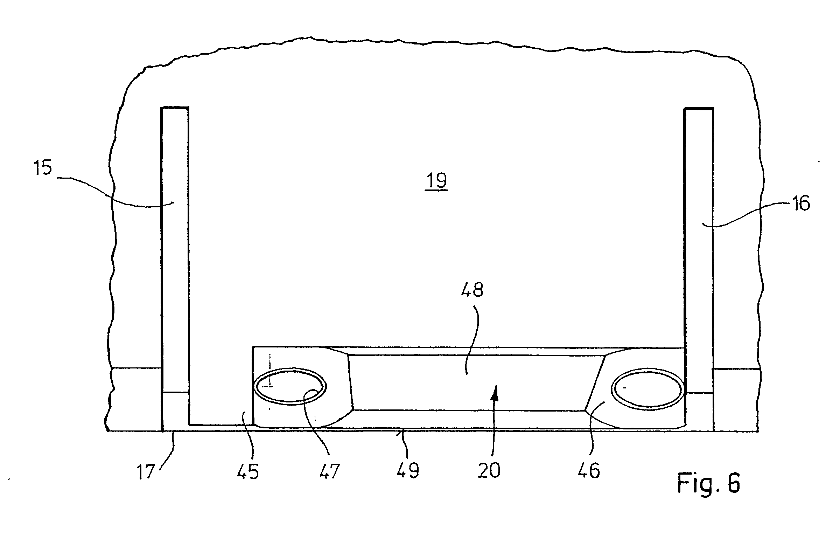

Die Seitenwand 2 weist außerdem zwei weitere Schlitze 15 und 16 auf, die senkrecht zu den Schlitzen 7 bis 10 verlaufen und sich von einer von den beiden Seitenwänden 2 und 4 gebildeten Kante 17 ausgehend über einen Teil der Seitenwand 2 erstrecken. Die beiden Schlitze 15 und 16 sind im Bereich der Kante 17 über einen weiteren Schlitz 18 (Fig. 2) verbunden, so daß über die Schlitze 15, 16 und 18 aus der Seitenwand 2 eine federnde Zunge 19 abgeteilt ist. Diese federnde Zunge 19 besitzt im Bereich der Kante 17 an ihrer Außenseite einen Nocken 20, dessen nähere Ausbildung und Funktion weiter unten zu Fig. 6 noch beschrieben wird.

An der dem Nocken 20 gegenüberliegenden Seite weist die Seitenwand 2 eine Ausnehmung 21 auf, die so ausgebildet ist, daß sie den Nocken 20 eines mit dem Gehäuse 1 verbundenen weiteren Gehäuses 1 aufnehmen kann.

Die federnde Zunge 14 ist als Steckverbindung 22 ausgebildet, über die mehrere Gehäuse 1 miteinander zu einem Gehäuseblock (der der Übersichtlichkeit halber in der Zeichnung nicht dargestellt ist) verbunden werden können. Die Steckverbindung 22 ist als Schwalbenschwanz-Führung 23 ausgeführt, wobei die federnde Zunge 14 ein eine Feder 24 bildendes Führungsstück 25 aufweist. Jeweils am Anfang und Ende des Führungsstücks 25 befinden sich Schrägflächen 26, die einem leichteren Einschieben der Führungsstücke zweier zu verbindender Gehäuse 1 dienen, und somit die Steckverbindung 22 bequem herstellbar ist.

Der Umfangswulst 6, der an einer beispielhaft dargestellten Trägerplatte 27 anliegt, weist Aufnahmen 28 zum Festlegen einer Frontwand 50 auf, deren Haltevorrichtungen 52 mit Rastnasen 53, die weiter unten noch näher beschrieben werden, in Ausnehmungen 29 einrasten.

Bei der in der Fig. 2 wiedergegebenen Seitenansicht des Gehäuses 1 ist die Seitenwand 3 erkennbar, die ebenfalls zwei Schlitze 30 und 31 aufweist. Diese Schlitze 30 und 31 bilden ebenfalls eine federnde Zunge 32, die einstückig mit der Seitenwand 3 verbunden ist und in deren Ebene liegt. Diese federnde Zunge 32 weist ein als Nut 33 ausgebildetes Führungsstück 34 auf, das Teil einer Schwalbenschwanzführung 23 ist. Das Führungsstück 34 weist beidseitig ebenfalls Schrägflächen 35 auf, die einer einfacheren Herstellung der Steckverbindung 22 dienen. Ferner sind am rückwärtigen Ende 11 Aufnahmen 36 vorgesehen, die über Ausnehmungen 37 mit Rastvorrichtungen 55 eines Deckels 54 (wie weiter unten noch näher beschrieben) verbindbar sind.

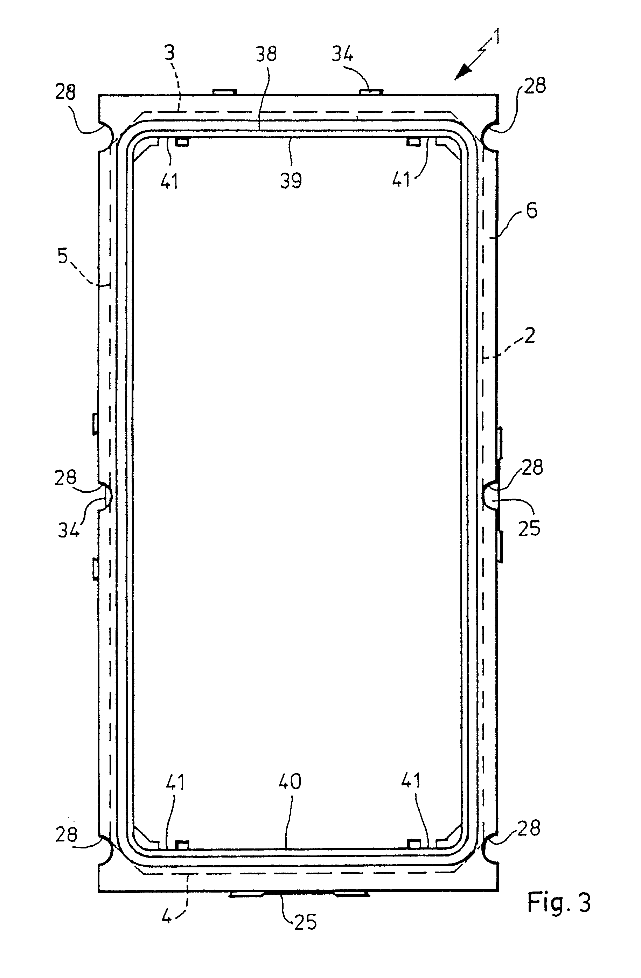

Bei der in der Fig. 3 wiedergegebenen Draufsicht auf die Stirnseite des Gehäuses 1 ist der Umfangswulst 6 erkennbar, der die Aufnahmen 28 aufweist. Außerdem sind die Führungsstücke 25 und 34 teilweise erkennbar, die in den Seitenwänden 2 und 4 bzw. 3 und 5 liegen. Weiterhin ist eine im Umfangswulst 6 sich befindende umlaufende Nut 38 erkennbar, die, wie ebenfalls weiter unten beschrieben, einen dichtenden Abschluß der Frontplatte 50 an den stirnseitigen Enden der Seitenwände 2 bis 5 gewährleistet. An den Innenflächen 39 und 40 der Seitenwände 3 und 4 sind Platinenführungsschienen 41 vorgesehen, in die Platinen durch die stirnseitige Öffnung des Gehäuses 1 eingeschoben werden können.

In der Fig. 2 ist erkennbar, daß die federnde Zunge 19 in der Ebene der Seitenwand 5 liegt, wobei die Seitenwand 5 der Seitenwand 2 entspricht. Außerdem ist zu erkennen, daß die federnde Zunge 19 eine geringere Dicke als die Seitenwand 5 aufweist, wodurch eine höhere Elastizität und damit ein leichteres Durchbiegen der Zunge 19 in Richtung des Schlitzes 18 ermöglicht wird.

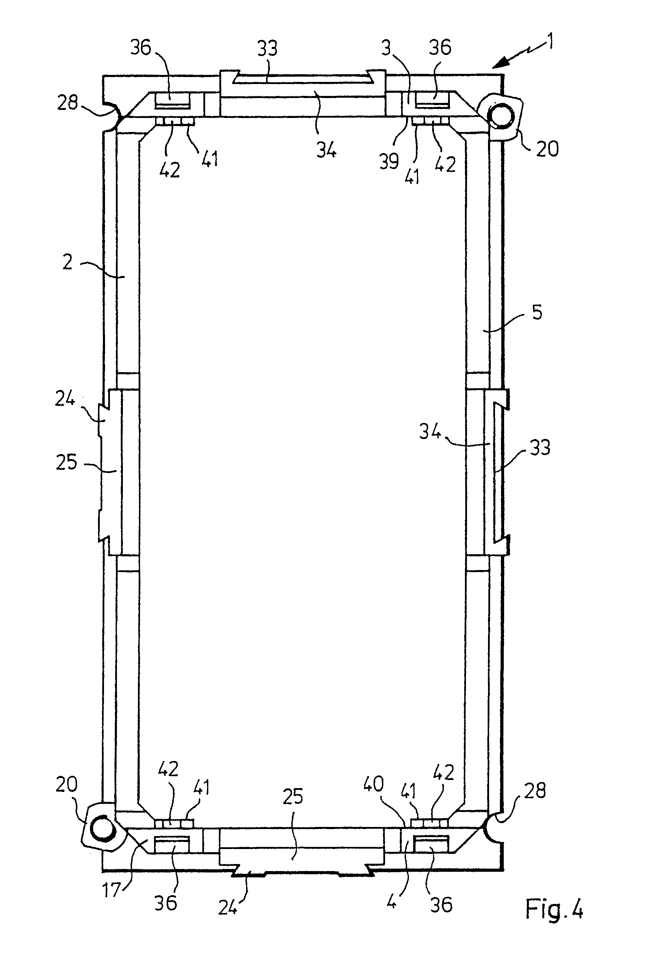

Die Fig. 4 zeigt das rückwärtige Ende 11 des Gehäuses 1. In dieser Ansicht ist erkennbar, daß jeweils zwei nebeneinander liegende Seitenwände 2 und 4 bzw. 3 und 5 gleich ausgebildete Führungsstücke 25 bzw. 34 aufweisen, wobei die Führungsstücke 25 mit Federn 24 und die Führungsstücke 34 mit jeweils einer Nut 33 versehen sind. Die Federn 24 und die Nuten 33 sind so ausgebildet, daß sie ineinander steckbar sind und eine Steckverbindung 22 bilden.

Ferner sind an den Innenflächen 39 und 40 die Platinenführungsschienen 41 erkennbar, die im Bereich des rückwärtigen Endes des Gehäuses 1 Platinensicherungen 42 aufweisen, die in eingeschobene Platinen eingreifen und diese in den Platinenführungsschienen 41 festhalten und gegen ein Herausrutschen sichern. Weiterhin sind die an der federnden Zunge 19 festgelegten Nocken 20 erkennbar, die die Außenfläche der Seitenwände 2 und 5 überragen.

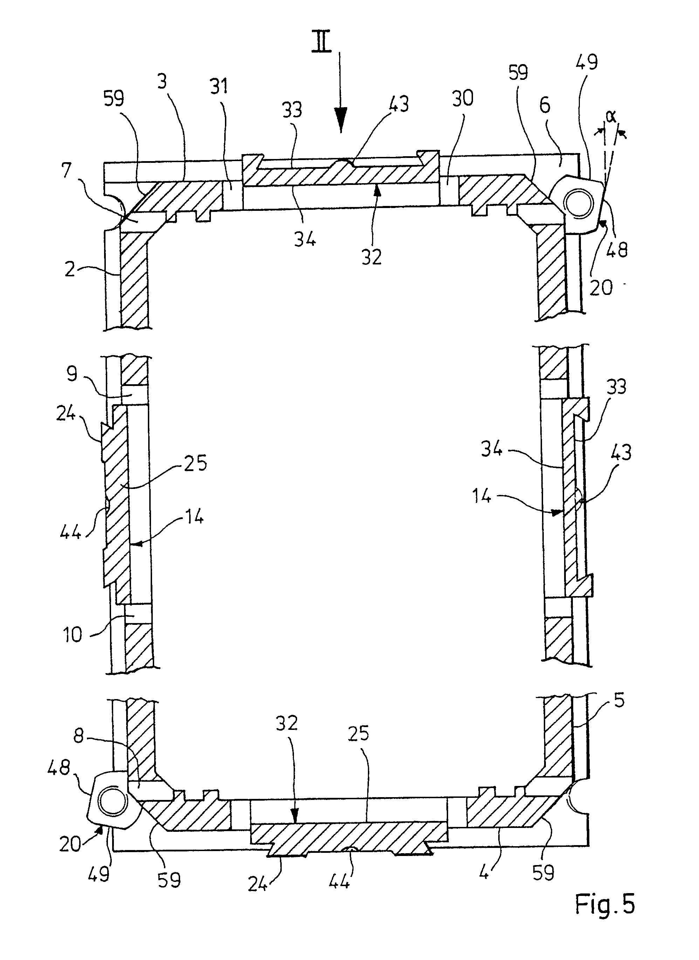

Der in der Fig. 5 dargestellte Schnitt V - V der Fig. 1 veranschaulicht die Lage der federnden Zungen 14 und 32 in den Seitenwänden 2 bis 5, wobei zu erkennen ist, daß die Dicke der federnden Zungen 14 und 32 geringer als die Dicke der Seitenwände 2 bis 5 ist. Außerdem weisen die Nuten 33 Arretiernasen 43 auf, die beim Einschub einer Feder 24 in die Nut 33 in Arretierausnehmungen 44 eingreifen, die in den Federn 24 der Führungsstükke 25 vorgesehen sind. Diese Arretiernasen 43 und Arretierausnehmungen 44 bilden Arretierrasten, die einen sicheren Zusammenhalt mehrerer miteinander verbundener Gehäuse gegen eine unzeitige Verschiebung gewährleisten.

Die Außenkontur des Gehäuses 1 wird von den Außenflächen der Seitenwände 2 bis 5 bestimmt, wobei sowohl aus der Fig. 4 als auch aus der Fig. 5 ersichtlich ist, daß die Nocken 20 der federnden Zungen 19 die Außenkontur überragen.

Der Nocken 20 ist, wie in Fig. 6 wiedergegeben, am freien Ende 45 der federnden Zunge 19 angeordnet und weist eine Größe auf, die höher als der Rand des Umfangswulstes 6 ist. Weiterhin ist der Nocken 20 an seinem dem rückwärtigen Ende 11 des Gehäuses 1 zugewandten Ende mit einer Schrägfläche 46 versehen. Das andere Ende des Nockens 20 ist ebenfalls mit einer Schrägfläche versehen, die einem leichten Ausschub des Gehäuses 1 aus dem Ausschnitt 60 dient. Der Nocken 20 ist mit einer längs verlaufenden Gewindebohrung 47 versehen und weist einen im wesentlichen rechteckförmigen Querschnitt auf. Wie in der Fig. 5 gezeigt, ist der Nocken 20 am freien Ende 45 der federnden Zunge 19 derart angeordnet, daß die Seitenflächen 48 und 49 des Nockens 20 unter einem Winkel $\alpha$ zu den Seitenwänden 5 und 3 bzw. 2 und 4 geneigt sind. Wird die federnde Zunge 19 um den Winkel $\alpha$ in den Schlitz 18 (Fig. 2) eingedrückt, so senkt sich der Nocken 20 mit der eingefederten Zunge 19 ebenfalls so weit ab, daß die Seitenfläche 48 parallel und somit bündig zu den Außenflächen der Seitenwände 2 und 5 verläuft. In dieser Lage verläuft die Seitenfläche 49 ebenfalls parallel und bündig zu den Außenflächen der Seitenwände 3 und 4.

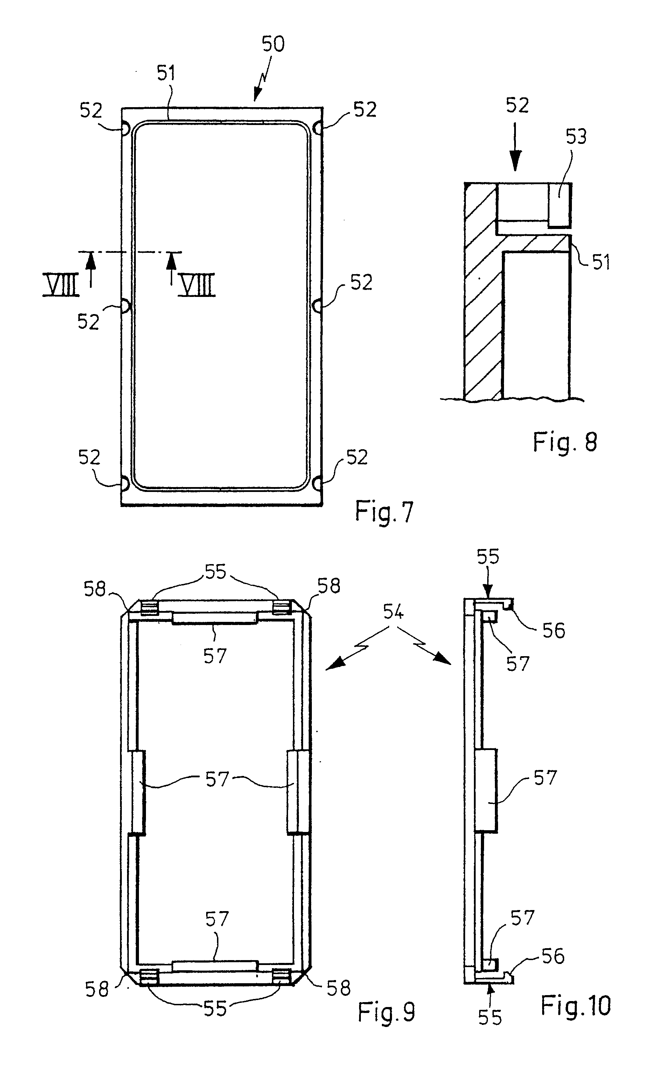

Die in den Fig. 7 und 8 wiedergegebene Frontwand 50 ist z.B. als durchsichtige klare oder farbige Kunststoffplatte oder als Aluminiumfrontplatte ausgebildet und weist einen umlaufenden Rand 51 auf, der in die umlaufende Nut 38 (Fig. 3) der Seitenwände 2 bis 5 einsetzbar ist. Außerdem sind an zwei einander gegenüberliegenden Seiten je drei Haltevorrichtungen 52 vorgesehen, die in die Aufnahmen 28 eingreifen, wobei eine am freien Ende einer jeden Haltevorrichtung 52 vorgesehene Rastnase 53 in die Ausnehmung 29 der Aufnahme 28 einrastet. Ist die Rastnase 53 in der Ausnehmung 29 eingerastet, so sitzt der Rand 51 in der Nut 38 und dichtet das Innere des Gehäuses 1 sicher gegen Staub und Schwallwasser gemäß der Schutzart IP 54 bzw. IP 56 ab. Eine weitere Verbesserung der Dichtung kann z.B. durch zusätzliche Verwendung eines Silikondichtungsmittels, das zusätzlich in die Nut 38 eingebracht wird, erreicht werden. Die Frontwand 50 ist zum nachträglichen Aufsetzen auf und zur separaten Abnahme vom Gehäuse 1 ausgebildet und kann entweder als Durchsichtfenster oder als Aufnahmeplatte z.B. für hinter einer Scheibe liegenden Vorwahlschalter oder dergleichen ausgebildet sein.

Mit den Fig. 9 und 10 ist ein Deckel 54 wiedergegeben, der dazu bestimmt ist, das Gehäuse 1 rückseitig abzuschließen. Der Deckel 54 weist hierfür an zwei einander gegenüberliegenden Seiten Rastvorrichtungen 55 auf, die in die Aufnahmen 36 eingreifen, wobei Rastnasen 56, die an den freien Enden der Rastvorrichtungen 55 vorgesehen sind, in die Ausnehmungen 37 eingreifen. Ferner ist der Deckel 54 mit Stützlappen 57 versehen, an denen sich die freien Enden der federnden Zungen 14 und 32 abstützen können. Diese Stützlappen 57 können sich, wie in den Figuren 9 und 10 dargestellt, entweder über einen Teil der Ränder des Deckels 54 oder über dessen ganze Länge bzw. Breite erstrecken. Außerdem weist der Deckel 54 im Bereich seiner Ecken Fasen 58 auf, die Fasen 59 entsprechen, die an den Kanten des Gehäuses 1, wie unter anderem in Fig. 5 wiedergegeben, vorgesehen sind. Der Deckel 54 kann mit Steckerdurchführungen (nicht dargestellt) ausgestattet sein, so daß ein Verbinden der einzelnen in den Gehäusen 1 untergebrachten Instrumente untereinander und mit den Versorgungs- bzw. Auswerteeinheiten leicht möglich ist.

Nachfolgend wird der Einbau des erfindungsgemäßen Gehäuses in einen Ausschnitt 60 einer Trägerplatte 27 beschrieben.

Nach dem Einsetzen des Instruments bzw. Anzeigegeräts bzw. deren Platinen in die Platinenführungsschienen 41 in das Gehäuse 1 kann dieses entweder mit aufgesetztem Deckel 54 und aufgesetzter Frontwand 55 oder mit offenen Enden, d.h. ohne Frontwand 50 und ohne Deckel 54 in den Ausschnitt 60 eingeführt werden. Dabei wird das rückwärtige Ende 11 des Gehäuses 1 in den Ausschnitt 60 eingeschoben, wodurch die federnden Zungen 14 und 32 geringfügig nach innen, d. h. in das Gehäuseinnere einfedern, bis schließlich die Schrägkante 46 der Nocke 20 an der Innenseite des Ausschnitts 60 anliegt. Ein Weiterschieben des Gehäuses 1 in den Ausschnitt 60 bewirkt ein Niederdrücken und somit Einfedern der federnden Zungen 19, was dadurch bewirkt wird, daß beim Entlanggleiten der Schrägfläche 46 an der Innenkante des Ausschnitts 60 der die Außenkontur die Seitenwände 2 und 5 überragende Teil des Nockens 20 in Richtung des Schlitzes 18 verdrängt wird. Der Nocken 20 wird dabei so weit verdrängt, bis dessen Seitenfläche 48 bündig mit der Seitenwand 2 bzw. 5 abschließt, und somit das Gehäuse 1 bis zur Anlage am Umfangswulst 6 in den Ausschnitt 60 eingeschoben werden kann. Nach dem Durchtritt des Nockens 20 durch den Ausschnitt 60 federt die federnde Zunge 19 wieder zurück in ihre Ausgangslage, so daß der Nocken 20 die Außenfläche der Seitenwand 2 bzw. 5 wieder teilweise überragt. Die Trägerplatte 27 befindet sich nun zwischen dem Umfangswulst 6 und dem Nocken 20. Eine feste Anlage des Umfangswulstes 6 an der Außenseite der Trägerplatte 27 wird durch Einschrauben einer in der Fig. 2 durch eine strichpunktierte Linie dargestellten Schraube 61 erreicht, die in der Gewindebohrung 47 des Nockens 20 festgelegt ist und an der Innenseite der Trägerplatte 27 angreift.

In dieser Lage kann das Gehäuse 1, falls nicht bereits geschehen, mit dem Deckel 54 und der Frontwand 50 versehen und mit anderen Geräten elektrisch verbunden werden.

Ein Entfernen des Gehäuses 1 aus dieser Lage erfolgt dadurch, daß die Schraube 61, über die das Gehäuse 1 an Trägerplatten 27 in unterschiedlicher Dicke anpaßbar ist, gelöst wird, und das Gehäuse 1 soweit ausgeschoben wird, bis die Innenfläche der Trägerplatte 27 am Nocken 20 anstößt. Der angeschrägte Nocken 20 wird dann ausgelenkt, d.h. die federnde Zunge 19 wird in den Schlitz 18 verschwenkt, so daß der Nocken 20 die Gehäusewand 2 bzw. 5 nicht mehr überragt. Sobald die Seitenfläche 48 des Nockens 20 bündig mit den Außenflächen der Seitenwand 2 bzw. 5 abschließt kann das Gehäuse 1 aus dem Ausschnitt 60 ausgezogen werden. Nach dem Durchtritt des Nockens 20 durch den Ausschnitt 60 federt die federnde Zunge 19 zurück in ihre Ausgangslage. Schließlich werden die federnden Zungen 14 und 32 wieder geringfügig nach innen verschwenkt und das Gehäuse 1 vollständig aus dem Ausschnitt 60 herausgezogen. Mit abgenommenem Deckel 54 lassen sich die federnden Zungen 14 und 32 einfacher nach Innen verschwenken, wobei jedoch ein Abnehmen des Deckels 54 nicht unbedingt erforderlich ist.

Das Gehäuse 1 kann, wie oben beschrieben, entweder als Einzelgehäuse in einen Ausschnitt 60 eingesetzt werden oder mit mehreren anderen Gehäusen 1 vor einem Einschieben zu einem Gebäudeblock oder Blockverbund vormontiert werden und schließlich dieser Blockverbund in einen entsprechend geformten Ausschnitt in die Trägerplatte 27 eingesetzt werden. Dieses Einsetzen vollzieht sich entsprechend der obigen Beschreibung, wobei der Gehäuseblock nunmehr über Schrauben 61 bzw. Gewindestifte gesichert wird, die an den äußeren Seitenwänden des Gehäuseblocks liegen.

Die Herstellung eines Gehäuseblocks erfolgt dadurch, daß zwei oder mehrere Gehäuse 1 derart aneinandergefügt werden, daß die Seitenwände 2 und 5 bzw. 3 und 4 zweier Gehäuse 1 einander zugewandt sind, und demnach die Führungsstücke 25 und 34, die Federn 24 und Nuten 33 aufweisen, ineinander geschoben werden können und eine Steckverbindung 22 bilden. Dabei rastet die Arretiernase 43 des einen Gehäuses 1 in die Arretierausnehmung 44 des anderen Gehäuses 1 und legt somit die beiden Gehäuse 1 bündig aneinander fest. Die Anzahl der auf diese Art miteinander zu einem Gehäuseblock zu verbindenden Gehäuse 1 ist nicht begrenzt. Die Steckverbindung 22 bietet ohne zusätzliche Hilfsmittel eine stabile Blockmontage der Gehäuse 1. Weiterhin verrasten die Nocken 20, die die Außenfläche der Seitenwände 2 und 5 überragen mit den Ausnehmungen 21 der anliegenden Gehäuse 1, so daß hierdurch ein weiterer Halt der einzelnen Gehäuse 1 aneinander erzeugt wird.

## Ansprüche

1. Gehäuse für Instrumente, wie Anzeigeinstrumente, Meßinstrumente, Schaltinstrumente oder dergleichen, zum Einbau in eine einen Ausschnitt aufweisende Trägerplatte, wobei das Gehäuse vier Seitenwände und eine Frontwand aufweist, dadurch gekennzeichnet, daß jede Seitenwand (2 - 5) eine Steckverbindung (22) aufweist, mit der die Steckverbindung (22) einer Seitenwand (2 - 5) eines benachbarten Gehäuses (1) derart verbindbar ist, daß die beiden Gehäuse (1) fest aneinander gekoppelt sind.

2. Gehäuse nach Anspruch 1, dadurch gekennzeichnet, daß die Steckverbindung (22) als Nut-Feder-Verbindung, insbesondere als Schwalbenschwanz-Führung (23) ausgebildet ist.

3. Gehäuse nach einem der vorhergehenden Ansprüche, dadurch gekennzeichnet, daß die Steckverbindung (22) positive und negative Führungsstücke (25 und 34) aufweist, wobei an zwei nebeneinanderliegenden Seitenwänden (2 und 3 bzw. 4 und 5) jeweils ein positives Führungsstück (25 oder 34) und an den anderen Seitenwänden (4 und 5 oder 2 und 3) jeweils ein negatives Führungsstück (34 oder 25) vorgesehen ist.

4. Gehäuse nach einem der vorhergehenden Ansprüche, dadurch gekennzeichnet, daß die Steckverbindungen (22) in einer senkrecht zur Ebene der Trägerplatte (27) verlaufenden Richtung miteinander verbindbar sind.

5. Gehäuse nach einem der vorhergehenden Ansprüche, dadurch gekennzeichnet, daß die Steckverbindungen (22) Arretierrasten (Arretiernasen 43 und Arretierausnehmungen 44) aufweisen, die die Gehäuse (1) in einer Lage festhalten, in der die Frontwände (50) bündig miteinander abschließen.

6. Gehäuse nach einem der vorhergehenden Ansprüche, dadurch gekennzeichnet, daß die Gehäuse (1) vor dem Einbau in die Trägerplatte (27) als Block vormontierbar sind.

7. Gehäuse nach einem der vorhergehenden Ansprüche, dadurch gekennzeichnet, daß die Steckverbindungen (22) in Führungsstücken (25 bzw. 34) vorgesehen sind.

8. Gehäuse nach Anspruch 8, dadurch gekennzeichnet, daß die Führungsstücke (25 bzw. 34) an federnden Zungen (14 bzw. 32), die sich insbesondere über etwa die halbe Gehäuselänge erstrekken, ausgebildet sind, wobei die Zungen (14 bzw. 32) insbesondere in der Ebene der Seitenwände (2 bis 5) liegen.

9. Gehäuse nach einem der vorhergehenden Ansprüche, dadurch gekennzeichnet, daß zwei einander gegenüberliegende Seitenwände (2 und 5 bzw. 3 und 4) Befestigungshalter (Nocken 20) aufweisen, über die sich das Gehäuse (1) an der Rückseite der Trägerplatte (27) abstützt, wobei zur Abstützung in jedem Befestigungshalter insbesondere eine Schraube (61) vorgesehen ist.

10. Gehäuse nach Anspruch 9, dadurch gekennzeichnet, daß der Befestigungshalter als federnde Zunge (19) ausgebildet ist.

11. Gehäuse nach Anspruch 10, dadurch gekennzeichnet, daß der Befestigungshalter eine Schrägfläche (46) aufweist, die beim Einschieben des Gehäuses (1) in den Ausschnitt (60) der Trägerplatte (27) am Rand des Ausschnitts (60) angreift und die federnde Zunge (19) auslenkt, die nach dem Einschieben hinter der Trägerplatte (27) in ihre Ausgangslage zurückschwenkt.

12. Gehäuse nach einem der vorhergehenden Ansprüche, dadurch gekennzeichnet, daß die Seitenwände (2 bis 5) im Bereich ihres rückwärtigen Endes (11) im Bereich ihrer Kanten über Längsschlitze (7 und 8) voneinander getrennt sind.

Fig. 1

Fig. 2

Fig. 3

Fig. 4

Fig.5

Fig. 6

15 16 19 48 20 46 49 47 45 17

Fig. 7

Fig. 8

Fig. 9

Fig. 10

# EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | GB-A-2118670 (ATMOS FRITZSCHING AND CO.) * Seite 1, Zeile 27 - Seite 2, Zeile 39; Figuren 1, 2 * | 1-4, 6 | H05K5/00 |
| D | & DE-A-3214528 --- | | |
| Y | US-A-4423465 (TENG-CHING ET AL.) * Spalte 1, Zeilen 1 - 28; Figuren 4, 5 * --- | 1-4, 6 | |
| A | FR-A-2123728 (SOCIETE CONSTRUCTION D'APPAREILLAGE) * Seite 1, Zeilen 1 - 3 * * Seite 1, Zeile 24 - Seite 2, Zeile 5 * --- | 1 | |
| A | US-A-3289852 (KAHN) * Anspruch 1; Figuren 1-5 * ----- | 1 | |

**RECHERCHIERTE SACHGEBIETE (Int. Cl.5)**

H05K
G01D

Der vorliegende Recherchenbericht wurde für alle Patentansprüche erstellt

| Recherchenort | Abschlußdatum der Recherche | Prüfer |
|---|---|---|
| BERLIN | 14 NOVEMBER 1990 | CLOSA, D |